# EUROPÄISCHE PATENTSCHRIFT

(11) **EP 1 446 829 B1**
(45) Veröffentlichungstag und Bekanntmachung des Hinweises auf die Patenterteilung: **02.01.2008**
(21) Anmeldenummer: 02785062.7
(22) Anmeldetag: 14.11.2002
(51) Int. Cl.: H01L 21/033

(54) **PHOTOLITHOGRAPHISCHES VERFAHREN ZUM AUSBILDEN EINER STRUKTUR IN EINEM HALBLEITERSUBSTRAT**
METHOD FOR FORMING A STRUCTURE IN A SEMICONDUCTOR SUBSTRATE
PROCEDE POUR REALISER UNE STRUCTURE DANS UN SUBSTRAT SEMI-CONDUCTEUR

(30) Priorität: 20.11.2001 DE 10156865
(43) Veröffentlichungstag der Anmeldung: 18.08.2004
(73) Patentinhaber: Infineon Technologies AG, 81669 München (DE)
(72) Erfinder: KIRCHHOFF, Markus, 01458 Ottendorf-Okrilla (DE); VOGT, Mirko, 01307 Dresden (DE); WEGE, Stephan, 01474 Weissing (DE); KATZWINKEL, Frank, 01109 Dresden (DE)
(74) Vertreter: Graf Lambsdorff, Matthias
(86) Internationale Anmeldenummer: PCT/DE2002/004223
(87) Internationale Veröffentlichungsnummer: WO 2003/046961

(56) Entgegenhaltungen:
- GB-A- 2 344 464
- US-A- 3 484 313
- US-A- 5 998 100
- US-A- 6 007 732
- US-B1- 6 296 780

## Beschreibung

Die Erfindung betrifft allgemein ein Strukturierungsverfahren für die Halbleitertechnologie bei dem eine Struktur in einem Halbleitersubstrat erzeugt wird.

Bei der Fertigung von Halbleiterbauelementen tritt häufig das Erfordernis auf, dass in einem Verfahrensschritt eine Strukturierung durch Ätzen durchgeführt werden muss, bei der die zu entfernenden Abschnitte mindestens teilweise durch ein Siliziumoxid oder Siliziumnitrid gebildet werden. Ein Beispiel hierfür ist die Herstellung von Halbleiterspeicherzellen, welche einen Grabenkondensator und einen Auswahltransistor aufweisen. Während der Grabenkondensator auf einer Seite mit dem Auswahltransistor elektrisch durch eine vergrabene Brücke ("buried strap") verbunden wird, wird auf der anderen Seite des Grabenkondensators ein Isolationsgebiet (STI, "shallow trench isolation") erzeugt, durch welches der Grabenkondensator von einer benachbarten Speicherzelle elektrisch isoliert wird. Die Erzeugung des STI-Isolationsgebiets erfolgt durch einen Strukturierungsschritt, bei welchem ein Oberflächenabschnitt entfernt wird, der durch einen Teilabschnitt des zuvor erzeugten Grabenkondensators gebildet wird. Dies bedeutet, dass nicht nur Silizium geätzt werden muss, sondern auch Siliziumoxid, da der Grabenkondensator in seinem oberen Abschnitt einen Isolationskragen aus Siliziumoxid aufweist. Da sich an der Oberfläche des zu entfernenden Abschnitts zumeist eine Siliziumnitridschicht.befindet, muß somit durch den Ätzprozeß auch Siliziumnitrid geätzt werden können.

Bezüglich der Erzeugung von STI-Isolationsgebieten bei der Herstellung der genannten Speicherzellen wird beispielhaft auf die deutschen Offenlegungsschriften DE 199 41 148 A1 und DE 199 44 012 A1 verwiesen.

In Anbetracht der lateralen Dimensionen des Grabenkondensators, die in der Größenordnung von 100 - 200 nm liegen, stellt der genannte Prozess der Erzeugung des STI-Isolationsgebiets höchste Anforderungen an die Lagegenauigkeit, Maßhaltigkeit und Flankensteilheit des anzuwendenden Ätzprozesses, da sich die zu erzeugende Flanke der zu ätzenden Vertiefung mit äußerst geringem lateralem Lagefehler innerhalb des Grabenkondensators auf der der Leitungsbrücke abgewandten Seite befinden muss.

Zur Erzeugung kleinster Strukturen auf der Halbleiteroberfläche als auch zur Einhaltung geringster Variationen der Strukturbreiten über den Chip, den Wafer oder das Los ist es notwendig, dass die Reflexion von Licht der Belichtungswellenlänge an der Waferoberfläche (Grenzfläche Photolack - Substrat) möglichst vollständig unterbunden wird, um störende Interferenzeffekte auszuschalten. Dies gilt besonders für Belichtungswellenlängen bei und unter 248 nm (193 nm, 157 nm) aufgrund der zunehmenden Reflektivität der Substrate und der zunehmenden Empfindlichkeit der eingesetzten Lacke. Weiterhin muss zur Erzielung einer möglichst großen Tiefenschärfe bei der Belichtung die zu belichtende Lackschicht möglichst dünn sein. Um die Strukturübertragung, insbesondere bei Kontaktlöchern, zu realisieren, ist es notwendig, dass die Lackschicht in den durch die photolithographische Maske erzeugten Bereichen vollständig entfernt wird, um bei nachfolgenden Verfahrensschritten eine exakte Strukturübertragung und somit ein funktionierendes Bauelement gewährleisten zu können.

Beim fotolithographischen Prozess wird die Form des strukturierten Lacks nach der Belichtung auch durch den Untergrund bestimmt. Besteht der Untergrund aus plasmachemisch abgeschiedenen siliziumhaltigen Isolatorschichten, beispielweise SiO, SiON oder SiN, kann die chemische Zusammensetzung des oberflächennahen Bereichs dieser Schichten das fotolithographische Ergebnis stark beeinflussen. Es können sogenannte "Lackfüße" ausgebildet werden, die ansonsten getrennte Lackbereiche verbinden, so dass bei der Strukturübertragung in unter dem Lack befindlichen Schichten diese nicht geätzt werden können und somit fehlerhafte Schaltkreise oder deren kompletter Ausfall resultieren. Mit der Verringerung der verwendeten Strukturgröße und damit der einzusetzenden Belichtungswellenlänge wird dieses Problem verstärkt, da dadurch der Abstand benachbarter Lackgebiete kleiner wird.

In der EP 0 492 253 A1 ist ein Photostrukturierungsverfahren beschrieben, bei welchem zwei Photoresistschichten verwendet werden. Eine obere, relativ dünne Photoresistschicht (Topresist) wird nach der Strukturierung mit einem siliziumhaltigen Agens resistent gegen Trockenätzen im Sauerstoffplasma gemacht. In diesem nachfolgenden Trockenätzschritt wird die Struktur des Topresists mit dem exakten Maß der für die Strukturierung verwendeten Maske und mit senkrechten Flanken in eine untere, relativ dicke Photoresistschicht (bottom resist) übertragen. In Folge der chemischen Verstärkung des strukturierten Topresists hat dieses Verfahren die Bezeichnung CARL (Chemische Aufweitung von Resist Linien) erhalten. Der Bottomresist dient während der Ätzung des Substrats als eigentliche Maske. Der Bottomresist selbst muss anschließend in einem speziellen Ätzverfahren, beispielsweise mit O₂ oder SO₂ entfernt werden. Derartige Photoresistmasken haben insbesondere während der Ätzung von Kontaktlöchern mit sehr hohem Aspektverhältnis den entscheidenden Nachteil, dass sich die aus dem Resist während der Ätzung entstehenden Polymere nicht kontrollieren lassen. Dadurch kann die oben dargestellte Problematik des Ausbildens der "Lackfüße" nur bedingt gelöst werden. Denn bei sehr kleinen Strukturen führt dies zu einer starken Reduktion des Ätzprozessfensters, wodurch auch hier Lackreste ("Lackfüsse") auf der freizulegenden Substratschicht zurückbleiben und dadurch ein Übertragen der Struktur in das Substrat in nachfolgenden Prozessschritten zumindest teilweise verhindern, wodurch die Funktionszuverlässigkeit des Bauelements nicht mehr gewährleistet ist.

Die Druckschrift US-A-6,007,732 beschreibt ein Strukturierungsverfahren, bei welchem auf ein Substrat eine amorphe Kohlenstoffschicht abgeschieden wird, auf die amorphe Kohlenstoffschicht eine Photoresistschicht abgeschieden wird, die Photoresistschicht strukturiert wird und als Ätzmaske für eine anschließende Ätzstrukturierung der amorphen Kohlenstoffschicht verwendet wird.

Aufgabe der Erfindung ist es, ein Strukturierungsverfahren zu schaffen, bei dem das Ausbilden kleiner Strukturen in das Halbleitersubstrat mit hoher Genauigkeit und Zuverlässigkeit erreicht werden kann.

Diese Aufgabe wird erfindungsgemäß durch ein Verfahren, das die Schritte nach Patentanspruch 1 aufweist, gelöst.

Ein wesentlicher Gedanke der Erfindung besteht darin, dass auf das Halbleitersubstrat zunächst eine anti-reflektierende Schicht aus einer organischen Substanz und darauf eine Kohlenstoffschicht als Pufferschicht ausgebildet wird. Erst auf diese Pufferschicht wird die Photoresistschicht abgeschieden, welche durch einen photolithographischen Schritt belichtet wird und somit eine Struktur in der Photoresistschicht ausgebildet wird. In einem weiteren Verfahrensschritt wird diese Struktur in die darunter angeordneten Schichten, die zumindest die Pufferschicht, die anti-reflektierenden Schicht sowie das Halbleitersubstrat umfassen, übertragen.

Dadurch kann erreicht werden, dass auch bei zu übertragenden Strukturen, die sehr klein sind, die Photoresistschicht auf der darunter angeordneten Pufferschicht in den erwünschten Bereichen nahezu vollständig entfernt wird.

Vorteilhaft ist es, wenn die Struktur in die unter der Photoresistschicht liegenden Schichten durch einen einzigen Ätzschritt, der vorteilhafterweise durch ein anisotropes Trockenätzverfahren durchgeführt wird, übertragen wird.

Bei einem bevorzugten Ausführungsbeispiel wird die Kohlenstoffschicht als dünne Schicht ausgebildet. Die Schichtdicke wird dabei vorteilhafterweise kleiner als 20 nm, insbesondere kleiner als 10 nm und bevorzugterweise mit einer Schichtdicke von etwa 5 nm ausgebildet. Vorteilhaft ist es, diese Pufferschicht durch ein plasmaunterstütztes Abscheideverfahren, beispielsweise durch ein PECVD-Verfahren, auszubilden.

Das erfindungsgemäße Verfahren eignet sich insbesondere zur Herstellung von Isolationsbereichen zwischen Grabenkondensatoren die in dem Halbleitersubstrat ausgebildet sind und welche in Verbindung mit einem Auswahltransistor als Speicherzelle eines Speicher-Bauelements in einem Speicherzellenfeld angeordnet sind. Die freigeätzten Bereiche zwischen den Grabenkondensatoren werden zum Erzeugen der Isolationsbereiche mit isolierendem Material aufgefüllt.

Weitere vorteilhafte Ausgestaltungen sind in den Unteransprüchen angegeben.

Nachfolgend wird ein Ausführungsbeispiel des erfindungsgemäßen Verfahrens anhand schematischer Zeichnungen näher erläutert. Es zeigen:

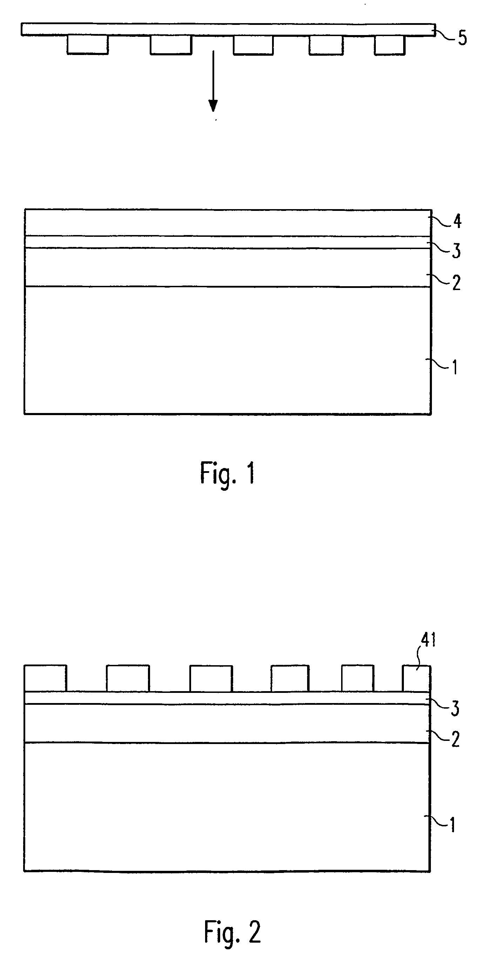

- Fig. 1 - 4: eine Darstellung der einzelnen Schritte des erfindungsgemäßen Strukturierungsverfahrens.

Im bekannten Stand der Technik wird zwischen einem Halbleitersubstrat und einer Photoresistschicht eine meist plasmachemisch abgeschiedene, siliziumhaltige Isolatorschicht erzeugt. Als Folge der Belichtung der Photoresistschicht bildet sich in dieser als Lackschicht ausgebildeten Resistschicht eine Säure. Aufgrund des relativ großen Diffusionskoeffizienten wird diese Säure nahezu im gesamten Bereich der belichteten Lackschicht wirksam und der Lack ist gut löslich. Die oben erwähnten Schichten unter der Resistschicht können aufgrund ihrer chemischen Zusammensetzung als Basen wirken und die in der Lackschicht gebildete Säure im Übergangsbereich zwischen der Resistschicht und dieser darunterliegenden Isolatorschicht neutralisieren. Dadurch verringert sich die Löslichkeit des Lacks in diesem Bereich und an Bereichen an denen die Isolatorschicht freigelegt und die Lackschicht entfernt werden soll verbleiben Lackreste. Diese verringern die Fensterbreite des eigentlich zu öffnenden Bereichs der Isolatorschicht und können bei kleinen Strukturen sogar derart bestehen bleiben, dass die Isolatorschicht in den Bereichen in denen sie freigelegt werden soll, auch nach dem Belichten noch vollständig mit einer dünnen Lackschicht bedeckt ist. Dieses Problem verstärkt sich mit der Verringerung der verwendeten Strukturgröße und der dafür einzusetzenden Belichtungswellenlänge, besonders bei Wellenlängen unterhalb 248 nm, insbesondere bei der 193 nm- oder der 157 nm-Lithogaphie.

Gemäß Fig. 1 wird zunächst ein zu strukturierendes Halbleitersubstrat 1 bereitgestellt, bei welchem es sich beispielsweise um einen Chip bzw. Wafer handeln kann, in welchen bereits eine matrixförmige Anordnung aus Grabenkondensatoren prozessiert worden ist, die in Verbindung mit jeweils einem Auswahltransistor jeweils eine Speicherzelle bilden. Durch den hier im folgenden beispielhaft dargestellten Strukturierungsprozess sollen zwischen den Grabenkondensatoren Isolationsbereiche, die auch als "Shallow Trench Isolation" (STI) bezeichnet werden, erzeugt werden. Da die zur Erzeugung der Isolationsbereiche zu entfernenden Abschnitte auch jeweils Teilabschnitte der prozessierten Grabenkondensatoren enthalten, muss demzufolge auch Siliziumoxid geätzt werden, da die Grabenkondensatoren im allgemeinen einen aus Siliziumoxid bestehenden Isolationskragen aufweisen.

Auf dieses Halbleitersubstrat 1 wird in einem nachfolgenden Verfahrensschritt eine anti-reflektierende Schicht 2 erzeugt. Diese anti-reflektierende Schicht 2 ist als organische Schicht ausgebildet und kann beispielweise an der Oberfläche eine Amino-Gruppe (NH₂) enthalten und durch eine bekannte Aufschleudertechnik aufgebracht werden. Diese anti-reflektierende Schicht 2 dient bei der Belichtung der Photoresistschicht dazu, Intensitätsschwankungen bei der Belichtung zu vermindern und dadurch lediglich Teilentwicklungen des Photolacks zu verhindern. Die Schicht 2 wird mit einer Schichtdicke kleiner als 70 nm und vorteilhafterweise mit einer Schichtdicke von etwa 45 nm ausgebildet.

Durch ein plasmaunterstütztes Abscheideverfahren wird auf die anti-reflektierende Schicht 2 eine Pufferschicht, die im Ausführungsbeispiel als Kohlenstoffschicht 3 ausgebildet wird, abgeschieden. Als Abscheideverfahren kann bevorzugt ein PECVD (plasma enhanced chemical vapor deposition) - Verfahren verwendet werden. Die Kohlenstoffschicht 3 kann dabei aus einer Vielzahl von organischen Substanzen abgeschieden werden. Beispielweise sei hierfür ein Prozess genannt, bei dem C₃H₆ mit einer Flussrate von 600 sccm und He mit einer Flussrate von 325 sccm in einen Reaktor eingebracht werden, in dem bei einer Temperatur von 550 °C, einem Druck von 8 h Pa (6 Torr) und einer Hochfrequenzleistung von 800 W aus den Prozessgasen die Kohlenstoffschicht 3 abgeschieden wird. Die Pufferschicht kann aber auch als kohlenstoffhaltige Schicht ausgebildet werden. Es kann auch vorgesehen sein ein HDP (High Density Plasma) - Verfahren zur Abscheidung der Kohlenstoffschicht 3 zu verwenden.

Die Kohlenstoffschicht 3 wird mit einer Schichtdicke kleiner 20 nm, insbesondere kleiner 10 nm abgeschieden. Für das Ausführungsbeispiel hat sich eine Schichtdicke von etwa 5 nm als am vorteilhaftesten erwiesen. Generell ist die Kohlenstoffschicht 3 möglichst dünn auszubilden, um die erzeugten Strukturen mittels eines einzigen Ätzschrittes in die Schichten 1 bis 3 zu übertragen. Darüber hinaus werden durch eine möglichst dünne Kohlenstoffschicht 3 die störenden Reflexionen bei der Belichtung der auf der Kohlenstoffschicht 3 ausgebildeten Photoresistschicht 4 gering gehalten. Diese Photoresistschicht 4 ist aus einem Negativ- oder Positivlack hergestellt und wird durch herkömmliche Belichtung mittels einer Chrommaske 5 belichtet.

Wie in Fig. 2 dargestellt werden die im Ausführungsbeispiel belichteten Bereiche entfernt, so dass Resistbereiche 41 auf der Kohlenstoffschicht 3 bestehen bleiben.

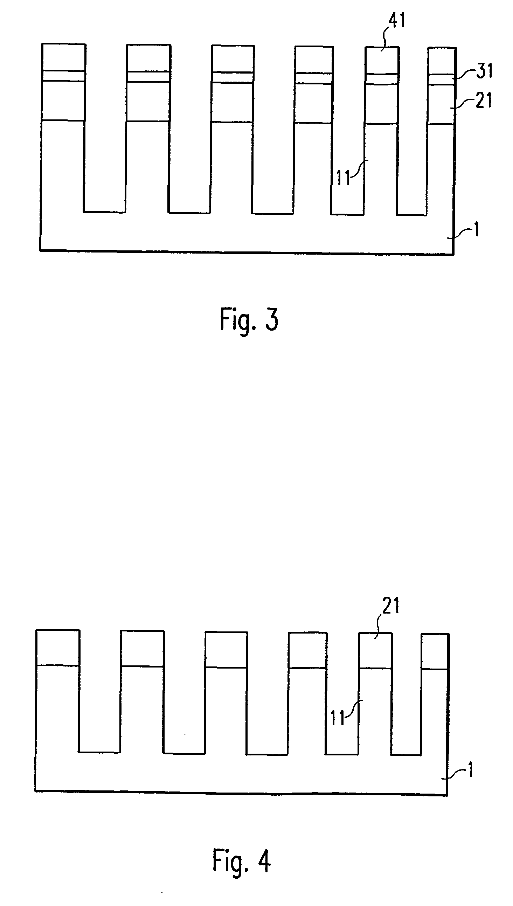

Gemäß Fig. 3 wird anschließend der eigentliche Strukturierungsprozess des Halbleitersubstrats 1 durch einen anisotropen Trockenätzschritt durchgeführt. Der Trockenätzschritt kann beispielsweise mit einem O₂-Plasma erfolgen, mit dem die Photoresistschicht 4, die Kohlenstoffschicht 3 sowie die aus organischem Material ausgebildete anti-reflektierende Schicht 2 geätzt wird. Unterhalb der Resistbereiche 41 verbleiben ungeätzte Bereiche des Substrats 1, in denen beispielsweise in dem oben genannten Anwendungsfall der Erzeugung von Isolationsbereichen fertig prozessierte Grabenkondensatoren und Auswahltransistoren von Speicherzellen angeordnet sein können.

Schließlich können in einem oder mehreren nachfolgenden Verfahrensschritten die Resistbereiche 41, sowie die strukturierten Bereiche 31 der Kohlenstoffschicht 3 und die strukturierten Bereiche 21 der anti-reflektierenden Schicht 2 entfernt werden. Die Bereiche 31 können durch einen einfachen Stripping-Prozess mit einem O₂-Plasma entfernt werden. Das in Form der Substratbereiche 11 strukturierte Substrat 1 ist in der Fig. 4 dargestellt.

Für die Erzeugung von Isolationsbereichen müssen in einem späteren, nicht dargestellten Verfahrensschritt die im Substrat 1 und der anti-reflektierenden Schicht 2 freigeätzten Bereiche durch ein geeignetes Isolationsmaterial aufgefüllt werden.

Die Ätzung der Kohlenstoffschicht 3 und der darunterliegenden Schichten 2 und 1 kann vorteilhafterweise mit Cl oder F enthaltende Ätzmedien durchgeführt werden. Bespielweise können Cl₂, BCl₃, SiCl₄, CCl₄, CHCl₃, CF4, CHF₃, C₂F₆, C₃F₈, C₄F₈ oder SF₆ verwendet werden.

Die Pufferschicht 3 soll nicht als Hartmaske für nachfolgende Ätzschritte ausgebildet werden, sondern dient insbesondere dazu eine chemische Entkopplung zwischen der Photoresistschicht 4 und der anti-reflektierenden Schicht 2 zu erzielen und dadurch die Strukturprofile in der Photoresistschicht 4 zu verbessern und exakter auszubilden.

Durch das Aufbringen der dünnen Pufferschicht als Kohlenstoff- oder kohlenstoffhaltige Schicht 3 unterhalb der Photoresistschicht 4 wird die chemische Wechselwirkung zwischen dem Lack der Resistschicht 4 und der anti-reflektierenden Schicht 2 auf dem Halbleitersubstrat 1 zumindest derart verhindert, dass die durch die Lithographiemaske in die Resistschicht 4 auszubildende Struktur zuverlässig erzeugt wird und nahezu keine "Lackfüsse" auf der Pufferschicht bestehen bleiben. Allgemein kann dies auch dadurch erreicht werden, dass als Pufferschicht eine derartige Schicht ausgebildet wird, deren chemische Zusammensetzung der chemischen Zusammensetzung der darüber ausgebildeten Resistschicht 4 sehr ähnlich ist. Insbesondere ist es dabei von Vorteil, wenn die Pufferschicht keine basisch wirkenden Aminogruppen enthält.

Durch das erfindungsgemäße Verfahren ist es somit möglich eine Entkopplung chemischer Reaktionen zwischen der Photoresistschicht 4 und der anti-reflektierenden Schicht 2 zu erzielen und dadurch sehr kleine Abmessungen reproduzierbar photolithographisch aufzulösen, wodurch diese kleinen Strukturen auch auf das Substrat 1 übertragen werden können. Indem die Pufferschicht sehr dünn ausgebildet wird werden die Reflexionseffekte gering gehalten und des Weiteren kann somit die Übertragung der Struktur von der Photoresistschicht 4 in alle darunter angeordneten Schichten durch einen einzigen Ätzschritt übertragen werden.

Somit ist die Dicke der Pufferschicht derart zu gestalten, dass diese Schicht zumindest so dick ist, um eine chemische Entkopplung zu ermöglichen andererseits aber so dünn gehalten werden muss, um Reflexionseffekte und Ätzprobleme kontrollieren zu können. Durch Ausbilden dieser Pufferschicht 3 kann auch das aufwändige Nachkontrollieren der Lackschicht 4 nach dem Belichtungsvorgang erheblich vermindert werden und ein nochmaliges Abtragen und erneutes Ausbilden der Lackschicht 4 und der darin erwünschten Lithographieestruktur reduziert werden, wodurch auch eine erhebliche Kosteneinsparung erzielt werden kann.

Das erfindungsgemäße Verfahren kann nicht nur für die STI-Isolation verwendet werden, sondern auch für alle anderen Lithographieschritte bei der Herstellung von Strukturen in einem Halbleitersubstrat.

## Patentansprüche

1. Verfahren zum Ausbilden einer Struktur in einem Halbleitersubstrat, das folgende Schritte aufweist:
a) Erzeugen einer anti-reflektierenden Schicht (2) aus einer organischen Substanz auf dem Halbleitersubstrat (1),
b) Ausbilden einer Kohlenstoffschicht (3) als Pufferschicht auf der anti-reflektierenden Schicht (2),
c) Abscheiden einer Photoresistschicht (4) auf der Pufferschicht,
d) Photolithographisches Erzeugen einer Struktur in der Photoresistschicht (4),
e) Übertragen dieser Struktur in die unter der Photoresistschicht (4) angeordnete anti-reflektierende Schicht (2), die Pufferschicht und das Halbleitersubstrat (1).

2. Verfahren nach einem der Anspruch 1,
**dadurch gekennzeichnet, dass**
die Pufferschicht mit einer Schichtdicke kleiner 20 nm ausgebildet wird.

3. Verfahren nach einem der Ansprüche 1 oder 2,
**dadurch gekennzeichnet, dass**
die Pufferschicht durch ein plasmaunterstütztes Abscheideverfahren erzeugt wird.

4. Verfahren nach Anspruch 3,
**dadurch gekennzeichnet, dass**
ein PECVD-Abscheideverfahren verwendet wird.

5. Verfahren nach einem der vorhergehenden Ansprüche,
**dadurch gekennzeichnet, dass**
in Verfahrensschritt e) die Struktur durch einen einzigen Ätzschritt erzeugt wird.

6. Verfahren nach Anspruch 5,
**dadurch gekennzeichnet, dass**
der Verfahrensschritt e) mit einem anisotropen Trockenätzschritt ausgeführt wird.

7. Verfahren nach einem der vorhergehenden Ansprüche,
**dadurch gekennzeichnet, dass**
die anti-reflektierende Schicht (2) mit einer Schichtdicke kleiner 70 nm, insbesondere mit einer Schichtdicke von etwa 45 nm, ausgebildet wird.

8. Verfahren zum Herstellen von Isolationsbereichen zwischen Bauelementen die in einem Halbleitersubstrat (1) ausgebildet werden, bei welchem
- das Halbleitersubstrat (1) nach einem oder mehreren der vorhergehenden Ansprüche strukturiert wird, und
- freigeätzte Bereiche zwischen den Bauelementen mit isolierendem Material aufgefüllt werden.

## Claims

1. Method for forming a pattern in a semiconductor substrate, which includes the following steps:
a) producing an antireflective layer (2) from an organic substance on the semiconductor substrate (1),
b) forming a carbon layer (3) as a buffer layer on the antireflective layer (2),
c) depositing a photoresist layer (4) on the buffer layer,
d) photolithographically producing a pattern in the photoresist layer (4),
e) transferring this pattern into the antireflective layer (2), the buffer layer and the semiconductor substrate (1) arranged below the photoresist layer (4).

2. Method according to Claim 1, **characterized in that** the buffer layer is formed.

3. Method according to one of Claims 1 or 2,
**characterized in that** the buffer layer is produced by a plasma-enhanced deposition process.

4. Method according to Claim 3, **characterized in that** a PECVD process is used.

5. Method according to one of the preceding claims,
**characterized in that**, in method step e), the pattern is produced by a single etching step.

6. Method according to Claim 5, **characterized in that** the method step e) is carried out by means of an anisotropic dry-etching step.

7. Method according to one of the preceding claims,
**characterized in that** the antireflective layer (2) is formed with a layer thickness of less than 70 nm, in particular with a layer thickness of approximately 45 nm.

8. Method for fabricating insulation regions between components which are formed in a semiconductor substrate (1), in which:
- the semiconductor substrate (1) is patterned as described in one or more of the preceding claims, and
- regions which have been etched clear between the components are filled with insulating material.

## Revendications

1. Procédé pour former une structure dans un substrat semi-conducteur, qui comporte les étapes suivantes :
a) production d'une couche (2) anti-réfléchissante en une substance organique sur le substrat (1) semi-conducteur,
b) formation d'une couche (3) en carbone en tant que couche tampon sur la couche (2) anti-réfléchissante,
c) dépôt d'une couche (4) de photorésist sur la couche tampon,
d) production par photolithographie d'une structure dans la couche (4) de photorésist,
e) transfert de cette structure dans la couche (2) anti-réfléchissante, la couche tampon et le substrat (1) semi-conducteur, qui sont disposés sous la couche (4) de photorésist.

2. Procédé suivant la revendication 1,
**caractérisé en ce que**
la couche tampon est réalisée en ayant une épaisseur de couche inférieure à 20 nm.

3. Procédé suivant l'une des revendications 1 ou 2,
**caractérisé en ce que**
la couche tampon est produite par un procédé de dépôt assisté par plasma.

4. Procédé suivant la revendication 3,
**caractérisé en ce que**
il est utilisé un procédé de dépôt PECVD.

5. Procédé suivant l'une des revendications précédentes,
**caractérisé en ce que**
à l'étape e) du procédé, la structure est produite par une étape d'attaque unique.

6. Procédé suivant la revendication 5,
**caractérisé en ce que**
l'étape e) de procédé est effectuée par une étape d'attaque sèche anisotrope.

7. Procédé suivant l'une des revendications précédentes,
**caractérisé en ce que**
la couche (2) anti-réfléchissante est réalisée en ayant une épaisseur de couche inférieure à 70 nm, notamment en ayant une épaisseur de couche d'environ 45 nm.

8. Procédé de fabrication de zones isolées entre des composants qui sont formés dans un substrat (1) semi-conducteur, dans lequel
- le substrat (1) semi-conducteur est structuré suivant l'une ou plusieurs des revendications précédentes, et
- des zones qui ne sont pas attaquées sont emplies entre les composants de matériau isolant.
